# EUROPEAN PATENT APPLICATION

(11) **EP 4 796 283 A1**
(43) Date of publication of application: **26.08.2026**
(21) Application number: 24879167.5
(22) Date of filing: 21.10.2024
(51) Int. Cl.: B29C 45/14, H01L 21/67, H01L 21/56, H01L 23/31, B29C 45/26, B29C 45/76

(54) **PLASTIC ENCAPSULATION MOLD AND PLASTIC ENCAPSULATION METHOD FOR SEMICONDUCTOR DEVICE, PRESSING DEVICE, AND DEVICE**

(30) Priority: 20.10.2023 CN 202311370687
(71) Applicant: Lite-on Microelectronics (Wuxi) Co., Ltd., Wuxi, Jiangsu 214028 (CN); Shanghai Seefull Electronic Co., Ltd., Shanghai 201619 (CN)
(72) Inventor: CHENG, Genbao, Wuxi, Jiangsu 214028 (CN); XU, Aiping, Wuxi, Jiangsu 214028 (CN); HE, Liuhong, Wuxi, Jiangsu 214028 (CN)
(74) Representative: Marks & Clerk LLP
(86) International application number: PCT/CN2024/126014
(87) International publication number: WO 2025/082527

(57) **Abstract**

A plastic encapsulation mold and a plastic encapsulation method for a semiconductor device, a pressing device, and the device. The mold comprises a pressing device and at least one mold cavity. The pressing device comprises a pressing pin. The mold cavity is used for accommodating a semiconductor device to be subjected to plastic encapsulation, the semiconductor device being provided with an exposed structure on a bottom surface of the mold cavity. A through hole is formed in a top surface of each mold cavity, the through hole corresponding to a non-chip placement region of the semiconductor device. The pressing pin is arranged corresponding to the through hole, thus ensuring that, before injection molding, the pressing pin enters the mold cavity through the through hole and presses against the exposed structure. During injection molding, the pressing pin leaves the exposed structure through the through hole. The mold of the present application comprises the pressing device; during plastic encapsulation, the pressing pin enters the mold cavity through the through hole in the mold cavity and presses against the non-chip placement region of the exposed structure of the semiconductor device, so that, under the action of pressure, a plastic encapsulation compound can be prevented from overflowing onto the exposed structure, thereby enhancing the heat dissipation performance of the exposed structure, and improving product quality.

## Description

The present application claims priority to Chinese Patent Application No. 202311370687.3, titled "PLASTIC ENCAPSULATION MOLD AND PLASTIC ENCAPSULATION METHOD FOR SEMICONDUCTOR DEVICE, PRESSING DEVICE, AND DEVICE", filed on October 20, 2023 with the China National Intellectual Property Administration, which is incorporated herein by reference in its entirety.

### FIELD

The present application relates to the field of semiconductors, and in particular to a plastic encapsulation mold and a plastic encapsulation method for a semiconductor device, a pressing device, and a semiconductor device.

### BACKGROUND

A bridge rectifier is provided with a heat sink to improve its heat dissipation performance. Currently, during its plastic encapsulation, a mold for encapsulating the bridge rectifier without the heat sink is still being used. During plastic encapsulation using the current plastic encapsulation mold, black epoxy resin overflows onto a heat dissipation surface of the heat sink, thereby impairing the heat dissipation performance of the heat sink and adversely affecting the product.

Therefore, how to address the above technical issues is a key focus for those skilled in the art.

### SUMMARY

An object of the present application is to provide a plastic encapsulation mold and a plastic encapsulation method for a semiconductor device, a pressing device, and a semiconductor device, in order to prevent encapsulant from overflowing onto a heat dissipation surface and enhance the heat dissipation performance.

In order to address the above technical issues, a plastic encapsulation mold for the semiconductor device is provided according to the present application. The plastic encapsulation mold includes a pressing device and at least one mold cavity.

The pressing device includes an ejector pin.

The mold cavity is configured to accommodate the semiconductor device to be encapsulated which has an exposed structure to a bottom surface of the mold cavity. Each mold cavity is formed with a through-hole in its top surface. The through-hole is positioned in alignment with a non-chip-placement region of the semiconductor device.

The ejector pin is positioned in alignment with the through-hole, and the ejector pin is configured to move through the through-hole into the mold cavity to press against the exposed structure prior to injection molding; and to move away from the exposed structure through the through-hole during the injection molding.

Optionally, there are at least two through-holes, and the number of through-holes is identical to the number of ejector pins.

Optionally, the pressing device further includes an ejector pin sleeve.

The ejector pin sleeve is arranged in the through-hole.

Optionally, the ejector pin sleeve is made of a material including tungsten steel, and the ejector pin is made of a material including high-speed steel.

Optionally, the ejector pin has a flat surface at its bottom portion, which is an end portion of the ejector pin for contact with the exposed structure.

Optionally, the exposed structure is a heat sink.

Optionally, the pressing device further includes a movement control device connected to a top portion of the ejector pin.

The movement control device is configured to control the ejector pin to press against and move away from the exposed structure. The top portion of the ejector pin is an end portion of the ejector pin away from the exposed structure.

Optionally, the movement control device includes a connecting plate and a pneumatic cylinder connected to the connecting plate.

The connecting plate is connected to the top portion of each ejector pin.

The pneumatic cylinder is configured to drive the connecting plate to move up and down.

Optionally, the plastic encapsulation mold further includes a buffer member.

The buffer member is arranged between the top portion of the ejector pin and the connecting plate.

Optionally, the buffer member includes a spring.

Optionally, the movement control device further includes a data acquisition module which is configured to acquire plastic encapsulation data, and the movement control device is configured to, based on the plastic encapsulation data, control the ejector pin to move away from the exposed structure prior to completion of plastic encapsulation.

Optionally, the plastic encapsulation data includes an elapsed plastic encapsulation duration. The ejector pin is configured to move away from the exposed structure when the elapsed plastic encapsulation duration reaches 60% to 85% of a total injection duration for plastic encapsulation.

Optionally, the plastic encapsulation data includes an amount of plastic encapsulation material used. The ejector pin is configured to move away from the exposed structure when the amount of plastic encapsulation material used reaches 60% to 85% of a total amount of plastic encapsulation material.

A plastic encapsulation method for a semiconductor device is further provided according to the present application, including the steps of:
placing the semiconductor device to be encapsulated into a mold cavity of a plastic encapsulation mold;
when the plastic encapsulation mold is closed, moving an ejector pin of a pressing device through a through-hole formed in a top surface of the mold cavity into the mold cavity to press against an exposed structure of the semiconductor device, where the through-hole is positioned in alignment with a non-chip-placement region of the semiconductor device, and the exposed structure is located at a bottom portion of the mold cavity; and
injecting encapsulant for plastic encapsulation, and controlling the ejector pin to move away from the exposed structure during injection molding.

Optionally, when the duration of the ejector pin pressing against the semiconductor device reaches 60% to 85% of a total injection duration for plastic encapsulation, the ejector pin is moved away from the semiconductor device.

Optionally, the step of moving the ejector pin of the pressing device through the through-hole into the mold cavity to press against the exposed structure of the semiconductor device includes:
when the plastic encapsulation mold is closed, sending an operational command to a controller from a proximity sensor configured to detect mold closing ; and
when the operational command is received by the controller, sending an activation command to a solenoid valve to control a movement control device such that the ejector pin is moved through the through-hole formed in the mold cavity into the mold cavity to press against the exposed structure of the semiconductor device, and sending a timing start command to a timer such that the timer is started to record the duration of the ejector pin pressing against the exposed structure; and
the step of controlling the ejector pin to move away from the exposed structure includes:
   when the duration received by the controller from the timer reaches 60% to 85% of the total injection duration for plastic encapsulation, sending a reset command to the solenoid valve to control the movement control device to reset such that the ejector pin is moved away from the exposed structure.

Optionally, when an amount of plastic encapsulation material used reaches 60% to 85% of the total amount of plastic encapsulation material, the ejector pin is moved away from the exposed structure.

Optionally, the step of injecting the encapsulant for plastic encapsulation includes:
performing a first encapsulant injection for plastic encapsulation; and
performing a second encapsulant injection for plastic encapsulation after the ejector pin is moved away from the exposed structure.

A pressing device for plastic encapsulation of a semiconductor device is further provided according to the present application. The pressing device includes an ejector pin, which is positioned in alignment with a through-hole formed in a top surface of a plastic encapsulation mold for the semiconductor device. The ejector pin is configured to move through the through-hole to press against a target location on the semiconductor device prior to injection molding, and move away from the target location through the through-hole during the injection molding.

Optionally, pressing device further includes an ejector pin sleeve.

The ejector pin sleeve is arranged in the through-hole.

Optionally, the pressing device further includes a movement control device connected to a top portion of the ejector pin.

The movement control device is configured to control the ejector pin to press against and move away from the target location. The top portion of the ejector pin is an end portion of the ejector pin away from the target location.

Optionally, the movement control device includes a connecting plate and a pneumatic cylinder connected to the connecting plate.

The connecting plate is connected to the top portion of each ejector pin.

The pneumatic cylinder is configured to drive the connecting plate to move up and down.

Optionally, the pressing device further includes a buffer member.

The buffer member is arranged between the top portion of the ejector pin and the connecting plate.

Optionally, the movement control device further includes a data acquisition module which is configured to acquire plastic encapsulation data, and the movement control device is configured to, based on the plastic encapsulation data, control the ejector pin to move away from the target location prior to completion of plastic encapsulation.

A semiconductor device is further provided according to the present application, which is plastic-encapsulated by using the plastic encapsulation mold described in any of the above embodiments.

A plastic encapsulation mold for a semiconductor device is provided according to the present application. The plastic encapsulation mold includes a pressing device and at least one mold cavity. The pressing device includes an ejector pin. The mold cavity is configured to accommodate the semiconductor device to be encapsulated which has an exposed structure to a bottom surface of the mold cavity. Each mold cavity is formed with a through-hole in its top surface. The through-hole is positioned in alignment with a non-chip-placement region of the semiconductor device. The ejector pin is positioned in alignment with the through-hole, and the ejector pin is configured to move through the through-hole into the mold cavity to press against the exposed structure prior to injection molding; and to move away from the exposed structure through the through-hole during the injection molding.

It can be seen that the plastic encapsulation mold in the present application includes the pressing device. During plastic encapsulation, the ejector pin is moved through the through-hole into the mold cavity to press against the non-chip-placement region of the exposed structure of the semiconductor device. Under the action of pressure, the plastic encapsulation material is prevented from overflowing and covering the exposed structure, thereby enhancing the heat dissipation performance of the exposed structure and improving product quality. In addition, a plastic encapsulation method, a pressing device, and a semiconductor device are further provided according to the present application.

### BRIEF DESCRIPTION OF THE DRAWINGS

In order to more clearly illustrate technical solutions in embodiments of the present application or in the conventional technology, the accompanying drawings required for describing the embodiments or the conventional technology will be briefly introduced below. Apparently, the drawings described below only relate to some embodiments of the present application. Based on these drawings, other drawings can be obtained by those ordinary skilled in the art without any creative effort.
FIG. 1 is a side view of a mold cavity of a plastic encapsulation mold in the relevant technology;
FIG. 2 is a top view of the mold cavity of the plastic encapsulation mold in the relevant technology;
FIG. 3 is a side view of a plastic encapsulation mold according to an embodiment of the present application;
FIG. 4 is a top view of the plastic encapsulation mold according to the embodiment of the present application;
FIG. 5 is a schematic view of a plastic encapsulation mold according to a first embodiment of the present application during plastic encapsulation;
FIG. 6 is a schematic view of a plastic encapsulation mold according to a second embodiment of the present application during plastic encapsulation;
FIG. 7 is a schematic view of a plastic encapsulation mold according to an third embodiment of the present application during plastic encapsulation;
FIG. 8 is a flow chart of a plastic encapsulation method for a semiconductor device according to a first embodiment of the present application; and
FIG. 9 is a flow chart of a plastic encapsulation method for a semiconductor device according to a second embodiment of the present application.

Numeral references in the drawings are listed as follows:

| | | | |
|---|---|---|---|
| 1. | ejector pin; | 2. | mold cavity; |
| 3. | heat sink; | 4. | encapsulant; |
| 5. | ejector pin sleeve; | 6. | connecting plate; |
| 7. | pneumatic cylinder; | 8. | support frame; |
| 9. | buffer member; | 10 . | exposed structure. |

### DETAILED DESCRIPTION OF THE EMBODIMENTS

To enable those skilled in the art to better understand the technical solutions of the present application, the present application is further described in detail below with reference to the accompanying drawings and specific embodiments. Apparently, the described embodiments are only some rather than all of the embodiments of the present application. Based on the embodiments of the present application, all other embodiments obtained by those skilled in the art without any creative effort fall within the protection scope of the present application.

Various details are illustrated in the following description to facilitate thorough understanding of the present application. However, the present application may be implemented in other ways than those described herein. Those skilled in the art may make analogous promotion without departing from the spirit of the present application. Hence, the present application is not limited to the embodiments disclosed below.

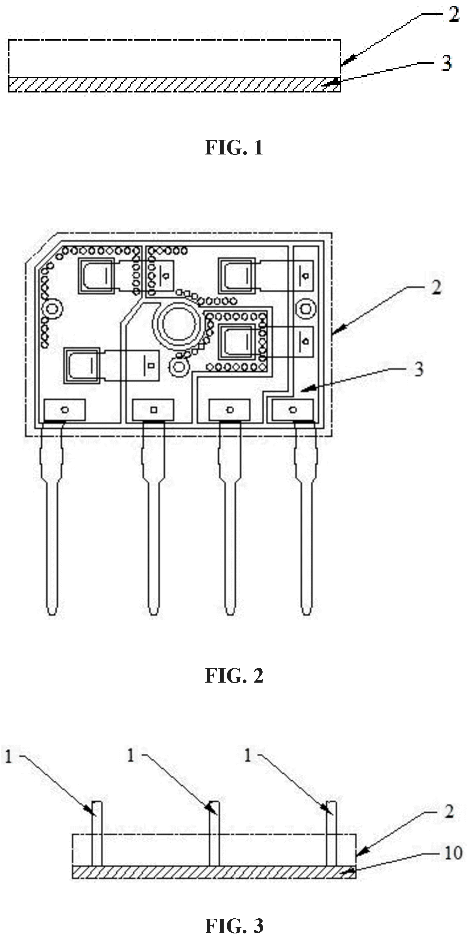

As described in the background, a bridge rectifier with a heat sink is currently encapsulated using a conventional plastic encapsulation mold. The schematic structural views of the mold cavity 2 of the conventional plastic encapsulation mold are shown in FIGS. 1 and 2. During plastic encapsulation, black epoxy resin overflows onto a heat dissipation surface of the heat sink 3, thereby impairing the heat dissipation performance of the heat sink and adversely affecting the product.

In view of this, a plastic encapsulation mold for a semiconductor device is provided according to the present application. Referring to FIGS. 3 to 5, the plastic encapsulation mold for the semiconductor device includes a pressing device and at least one mold cavity 2.

The pressing device includes an ejector pin 1.

The mold cavity 2 is configured to accommodate the semiconductor device to be encapsulated which has an exposed structure to a bottom surface of the mold cavity 2. Each mold cavity 2 is formed in its top surface with a through-hole, which is positioned in alignment with a non-chip-placement region of the semiconductor device.

The ejector pin 1 is positioned in alignment with the through-hole, and the ejector pin 1 is configured to move through the through-hole into the mold cavity 2 to press against an exposed structure 10 prior to injection molding, and moved away from the exposed structure 10 through the through-hole during the injection molding.

In the present application, the movement of the ejector pin 1 away from the exposed structure 10 means that the ejector pin 1 is separated from at least the encapsulant 4, allowing the ejector pin 1 to be separated from the plastic encapsulation mold.

The exposed structure 10 includes, but is not limited to, a heat sink.

The mold cavity 2 in this embodiment is structurally similar to that of the plastic encapsulation mold in the conventional technology, except that it is formed with the through-hole matching the ejector pin 1.

In this embodiment, the number of through-holes is not limited and may be determined as required. For example, there may be only one through-hole, which is formed at the center of the exposed structure to achieve force balance. Alternatively, there may be at least two through-holes, and the number of through-holes is identical to the number of ejector pins 1.

The number of through-holes in each mold cavity 2 corresponds to the number of ejector pins 1 pressing against the exposed structure 10. In the case that there are two or more through-holes in each mold cavity, each exposed structure 10 is pressed by the ejector pins 1 at two or more points, which easily ensure force balance across the exposed structure 10, preventing any side of the exposed structure 10 from lifting up and thereby preventing the encapsulant 4 from overflowing onto the exposed structure 10.

It should be noted that the number of mold cavities 2 is not defined in the present application and may be determined as required.

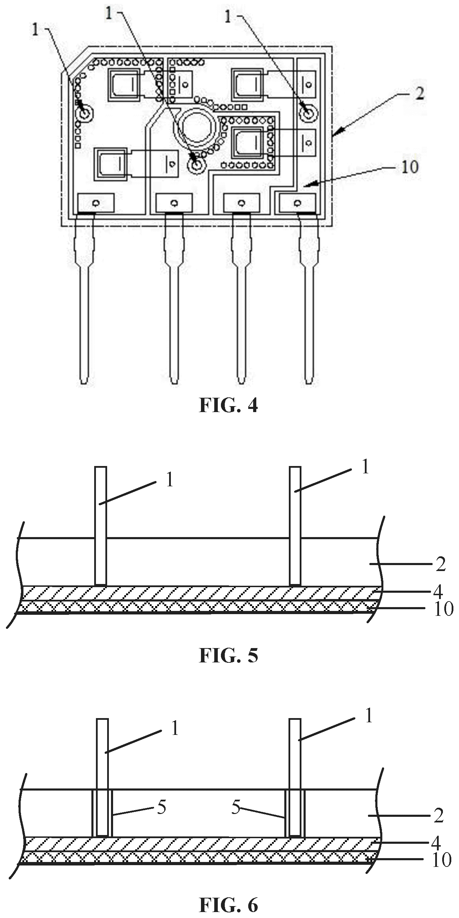

It should also be noted that when there are two or more through-holes in each mold cavity, the number of through-holes in each mold cavity 2 is not defined in this embodiment and may be determined as required. For example, each mold cavity 2 may be formed with two through-holes, as shown in FIG. 5; or three through-holes, as shown in FIGS. 3 and 4; or four through-holes and so on.

The through-hole in the mold cavity 2 is positioned in alignment with the non-chip-placement region of the exposed structure 10. That is, during plastic encapsulation, the non-chip-placement region of the exposed structure 10 is pressed by the ejector pin 1, preventing the encapsulant 4 from overflowing onto the exposed structure 10.

To prevent damage to the exposed structure 10 caused by the ejector pin 1 pressing against it, in a possible embodiment, the ejector pin 1 has a flat surface at its bottom portion, which is an end portion of the ejector pin 1 for contact with the exposed structure 10.

The ejector pin 1 has a cross-sectional shape that includes, but is not limited to, circular, square, rectangular, or elliptical shapes.

When the plastic encapsulation mold in this embodiment is utilized for performing plastic encapsulation, as shown in FIG. 5, the exposed structure 10 is positioned in the mold cavity 2, and after injection molding is complete, the encapsulant 4 is located on the exposed structure 10.

It should be noted that, in this embodiment, there is no limitation on the manner of controlling the ejector pin 1 to press against and move away from the exposed structure 10. For example, the ejector pin 1 may be manually operated or controlled by an automated apparatus.

The plastic encapsulation mold in this embodiment includes the pressing device. During plastic encapsulation, the ejector pin 1 is moved through the through-hole into the mold cavity 2 to press against the non-chip-placement region of the exposed structure 10 of the semiconductor device. Under the action of pressure, the plastic encapsulation material is prevented from overflowing and covering the exposed structure, thereby enhancing the heat dissipation performance of the exposed structure 10 and improving product quality.

Referring to FIG. 6, based on the above embodiment, in an embodiment of the present application, the pressing device in the plastic encapsulation mold for the semiconductor device may further include an ejector pin sleeve 5, which is arranged in the through-hole.

During the process of the ejector pin 1 pressing against and moving away from the exposed structure 10, frictional contact may be generated between the ejector pin 1 and the mold cavity 2, causing wear on both the ejector pin 1 and the mold cavity 2. After long-term and repeated use, the ejector pin 1 and the mold cavity 2 may become damaged to such an extent that they can no longer be used and must be replaced. However, replacing the mold cavity 2 is relatively costly. In this embodiment, by arranging the ejector pin sleeve 5, frictional contact may be generated between the ejector pin 1 and the ejector pin sleeve 5 during the process of the ejector pin 1 pressing against and moving away from the exposed structure 10. When the ejector pin 1 and the ejector pin sleeve 5 become damaged and unusable, it is sufficient to replace only the ejector pin 1 and the ejector pin sleeve 5 without replacing the mold cavity 2, thereby reducing the cost of plastic encapsulation.

In a possible embodiment, the ejector pin sleeve 5 is made of a material including tungsten steel, and the ejector pin 1 is made of a material including high-speed steel.

Tungsten steel has high hardness and excellent wear resistance, which can prolong the service life of the ejector pin sleeve 5. Additionally, the carbon contained in tungsten steel can provide a lubricating effect between the ejector pin 1 and the ejector pin sleeve 5 during their contact.

High-speed steel has the characteristics of excellent wear resistance and good toughness, making the ejector pin 1 less prone to fracture during the process of pressing against the exposed structure 10, thereby prolonging the service life of the ejector pin 1 and reducing the cost of plastic encapsulation.

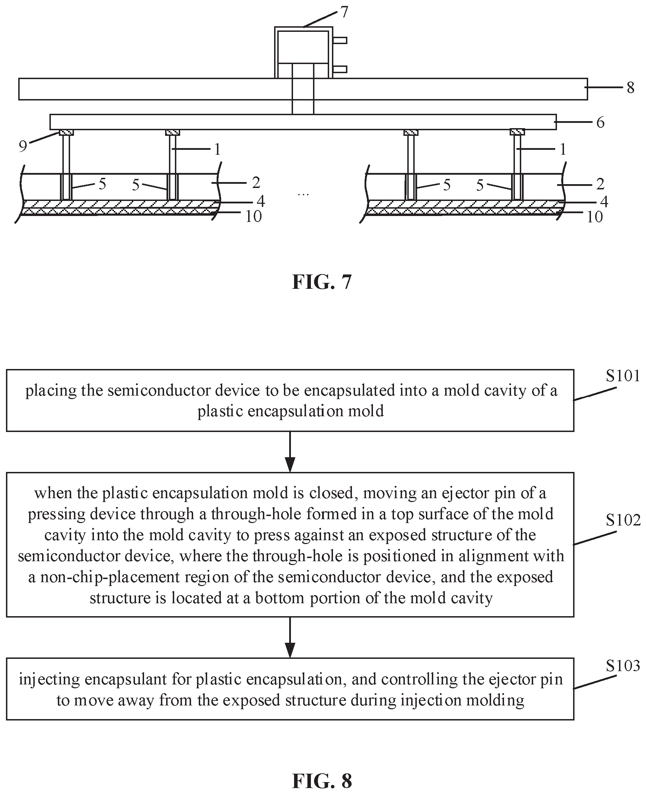

Based on any of the above embodiments, in an embodiment of the present application, as shown in FIG. 7, the pressing device in the plastic encapsulation mold for the semiconductor device may further include a movement control device connected to a top portion of the ejector pin 1.

The movement control device is configured to control the ejector pin 1 to press against and move away from the exposed structure 10. The top portion of the ejector pin 1 is an end portion of the ejector pin 1 away from the exposed structure 10.

The movement control device enables automatic control of the ejector pin 1 to press against and move away from the exposed structure 10, which is highly convenient, rapid, and saves labor.

The movement control device includes a connecting plate 6 and a pneumatic cylinder 7 connected to the connecting plate 6.

The connecting plate 6 is connected to the top portion of each ejector pin 1.

The pneumatic cylinder 7 is configured to drive the connecting plate 6 to move up and down.

The pneumatic cylinder 7 may be fixed to a support frame 8.

Since the connecting plate 6 is connected to all the ejector pins 1, the movement of the connecting plate 6 by the pneumatic cylinder 7 causes all the ejector pins 1 to move synchronously.

In an embodiment of the present application, the plastic encapsulation mold for the semiconductor device may further include a buffer member 9.

The buffer member 9 is arranged between the top portion of the ejector pin 1 and the connecting plate 6.

The buffer member 9 includes a spring or other elastic members.

The buffer member 9 is configured to buffer the pressure exerted by the ejector pin 1, thereby preventing damage to the exposed structure 10 caused by excessive pressure from the ejector pin 1 pressing against the exposed structure 10.

Based on the above embodiments, in an embodiment of the present application, the movement control device may further include a data acquisition module which is configured to acquire plastic encapsulation data, and the movement control device is configured to, based on the plastic encapsulation data, control the ejector pin to move away from the exposed structure prior to the completion of the plastic encapsulation.

In a possible embodiment, the plastic encapsulation data may include an elapsed plastic encapsulation duration. When the elapsed plastic encapsulation duration reaches 60% to 85% of a total injection duration for plastic encapsulation, the ejector pin is moved away from the exposed structure.

In another possible embodiment, the plastic encapsulation data may include an amount of plastic encapsulation material used. When the amount of plastic encapsulation material used reaches 60% to 85% of a total amount of plastic encapsulation material, the ejector pin is moved away from the exposed structure.

When the elapsed plastic encapsulation duration reaches 60% to 85% of the total injection duration for plastic encapsulation or the amount of plastic encapsulation material used reaches 60% to 85% of the total amount of plastic encapsulation material, the ejector pin is controlled to move away from the exposed structure. This, on the one hand, prevents the encapsulant from overflowing and covering the exposed structure 10, and on the other hand, ensures that the ejector pin is moved away from the exposed structure 10, and also avoids the formation of voids on the semiconductor device caused by the ejector pin 1.

A plastic encapsulation method for a semiconductor device by using the plastic encapsulation mold described in the above embodiments is further provided according to the present application. Referring to FIG. 8, the plastic encapsulation method includes the following steps S101 to S103.

In step S101, the semiconductor device to be encapsulated is placed into a mold cavity of a plastic encapsulation mold.

In step S102, when the plastic encapsulation mold is closed, an ejector pin of a pressing device is moved through the through-hole formed in a top surface of the mold cavity into the mold cavity to press against an exposed structure of the semiconductor device, wherein the through-hole is positioned in alignment with a non-chip-placement region of the semiconductor device, and the exposed structure is located at a bottom portion of the mold cavity.

In step S103, encapsulant is injected for plastic encapsulation, and the ejector pin is controlled to move away from the exposed structure during injection molding.

In a possible embodiment, injecting the encapsulant for plastic encapsulation includes:
performing a first encapsulant injection for plastic encapsulation; and
performing a second encapsulant injection for plastic encapsulation after the ejector pin is moved away from the exposed structure.

That is, injecting the encapsulant for plastic encapsulation may be divided into two steps. However, there is no specific restriction in this regard in the present application, and injecting the encapsulant may alternatively be completed in a single step.

In an embodiment of the present application, when the duration of the ejector pin pressing against the exposed structure reaches 60% to 85% of the total injection duration for plastic encapsulation, the ejector pin is moved away from the exposed structure. For instance, if the total injection duration for plastic encapsulation is 10 seconds, the duration of the ejector pin pressing against on the exposed structure ranges from 6 seconds to 8.5 seconds. Alternatively, when the amount of plastic encapsulation material used reaches 60% to 85% of the total amount of plastic encapsulation material, the ejector pin is moved away from the exposed structure.

The encapsulant is initially in a liquid state with relatively high fluidity. When the duration of the ejector pin pressing against the exposed structure is less than 60% of the total injection duration for plastic encapsulation, or when the amount of plastic encapsulation material used has not yet reached 60% of the total amount of plastic encapsulation material, the fluidity of the encapsulant remains relatively high. If the ejector pin is removed at this time, the encapsulant may still overflow onto the heat dissipation surface of the exposed structure, thereby adversely affecting the heat dissipation effect of the exposed structure. When the duration of the ejector pin pressing against the exposed structure is more than 85% of the total injection duration for plastic encapsulation, or when the amount of plastic encapsulation material used has exceeded 85% of the total amount of plastic encapsulation material, the encapsulant exhibits a relatively high degree of curing, and two issues may arise. On the one hand, the ejector pin fails to be removed, that is, the ejector pin is fixed to the exposed structure by the encapsulant. On the other hand, even if the ejector pin may be removed, the hole formed by the ejector pin will be left in the fully cured encapsulant, affecting the quality of the exposed structure. Furthermore, the ejector pin is prone to damage.

In the plastic encapsulation method according to this embodiment, the ejector pin is moved through the through-hole in the mold cavity into the mold cavity to press against the non-chip-placement region of the exposed structure of the semiconductor device. Under the action of pressure, the encapsulant may be prevented from overflowing onto the heat dissipation surface of the exposed structure, thereby enhancing the heat dissipation performance of the exposed structure and improving product quality.

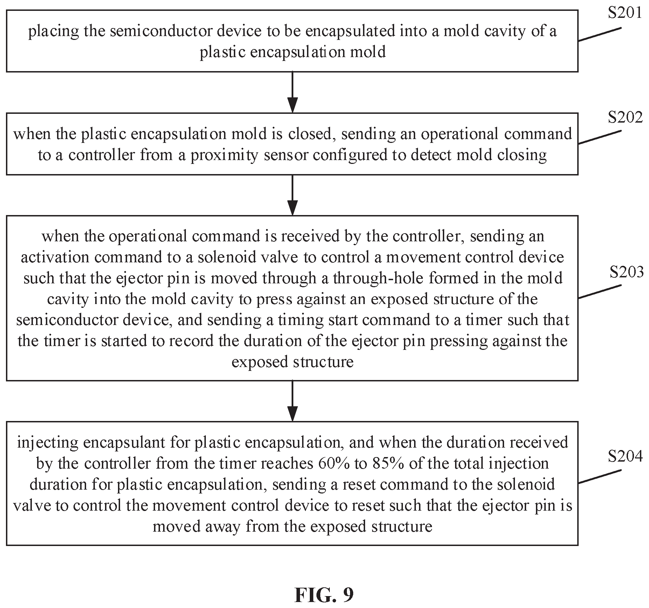

Based on the above embodiments, in an embodiment of the present application, a plastic encapsulation method for a semiconductor device may be controlled to be performed automatically. Referring to FIG. 9, the plastic encapsulation method includes the following steps S201 to S204.

In step S201, the semiconductor device to be encapsulated is placed into a mold cavity of a plastic encapsulation mold.

In step S202, an operational command is sent to a controller from a proximity sensor configured to detect mold closing when the plastic encapsulation mold is closed.

In step S203, when the operational command is received by the controller, an activation command is sent by the controller to a solenoid valve to control the movement control device such that the ejector pin is moved through the through-hole formed in the mold cavity into the mold cavity to press against an exposed structure of the semiconductor device; and a timing start command is sent by the controller to a timer such that the timer is started to record the duration of the ejector pin pressing against the exposed structure.

The solenoid valve is connected to the pneumatic cylinder of the movement control device, and the ejector pin is controlled by the pneumatic cylinder to press against the non-chip-placement region of the exposed structure. When the ejector pin presses against the exposed structure, the plastic encapsulation begins and the timer starts recording the duration.

In step S204, encapsulant is injected for plastic encapsulation, and when the duration received by the controller from the timer reaches 60% to 85% of the total injection duration for plastic encapsulation, a reset command is sent by the controller to the solenoid valve to control the movement control device to reset such that the ejector pin is moved away from the exposed structure.

The solenoid valve is configured to control the movement device to reset, that is, the ejector pin is driven by the pneumatic cylinder to move away from the surface of the exposed structure until the plastic encapsulation is completed.

A pressing device for plastic encapsulation of a semiconductor device is further provided according to the present application. The pressing device includes an ejector pin, which is positioned in alignment with a through-hole formed in a top surface of a plastic encapsulation mold for the semiconductor device. The ejector pin is configured to move through the through-hole to press against a target location on the semiconductor device prior to injection molding, and move away from the target location through the through-hole during injection molding.

The pressing device may be applied in the plastic encapsulation process of the semiconductor device to exert a certain pressure on the target location of the semiconductor device. For example, the target location may be a non-chip-placement region of the exposed structure of the semiconductor device so as to prevent the encapsulant from overflowing onto the surface of the exposed structure during plastic encapsulation.

In order to prevent frictional damage to the plastic encapsulation mold caused by the ejector pin during the process of pressing against and moving away from the semiconductor device, the pressing device may further include an ejector pin sleeve.

The ejector pin sleeve is arranged in the through-hole.

The ejector pin sleeve is made of a material including tungsten steel, and the ejector pin is made of a material including high-speed steel.

Tungsten steel has high hardness and excellent wear resistance, which can prolong the service life of the ejector pin sleeve. Additionally, the carbon contained in tungsten steel can provide a lubricating effect between the ejector pin and the ejector pin sleeve during their contact.

High-speed steel has the characteristics of excellent wear resistance and good toughness, making the ejector pin less prone to fracture during the process of pressing against the exposed structure, thereby prolonging the service life of the ejector pin and reducing the cost of plastic encapsulation.

Based on any of the above embodiments, in an embodiment of the present application, the pressing device further includes a movement control device connected to a top portion of the ejector pin.

The movement control device is configured to control the ejector pin to press against and move away from the target location. The top portion of the ejector pin is an end portion of the ejector pin away from the target location.

The ejector pin may be automatically controlled by the movement control device, which is very convenient.

In a possible embodiment, the movement control device includes a connecting plate and a pneumatic cylinder connected to the connecting plate.

The connecting plate is connected to the top portion of each ejector pin.

The pneumatic cylinder is configured to drive the connecting plate to move up and down.

In order to prevent damage to the exposed structure caused by excessive pressure from the ejector pin pressing against the exposed structure, the pressing device may further include a buffer member.

The buffer member is arranged between the top portion of the ejector pin and the connecting plate.

The buffer member may be an elastic member such as a spring.

Based on the above embodiments, in an embodiment of the present application, the movement control device may further include a data acquisition module which is configured to acquire plastic encapsulation data, and the movement control device may be configured to, based on the plastic encapsulation data, control the ejector pin to move away from the target location prior to the completion of plastic encapsulation. The plastic encapsulation data may include an elapsed plastic encapsulation duration or an amount of plastic encapsulation material used.

A semiconductor device is further provided according to the present application, which is plastic-encapsulated by using the plastic encapsulation mold described in any of the above embodiments.

The semiconductor device in this embodiment may be a bridge rectifier with an exposed structure. After plastic encapsulation, there will be no encapsulant on the heat dissipation surface of the exposed structure, thereby enhancing the heat dissipation performance.

The semiconductor device in this embodiment has the same structure as that obtained by a conventional plastic encapsulation mold, except that there is no encapsulant on the heat dissipation surface of the exposed structure of the semiconductor device in this embodiment.

The above embodiments are described in a progressive manner herein. Each of the embodiments is mainly focused on describing its differences from other embodiments, and reference may be made among these embodiments with respect to the same or similar parts.

The plastic encapsulation mold and the plastic encapsulation method for the semiconductor device, the pressing device, and the semiconductor device according to the present application are described in detail above. The principles and embodiments of the present application are described by specific examples. The embodiments are illustrated to facilitate understanding the method and core concept of the present application. It should be noted that those skilled in the art may make several improvements and modifications to the present application without departing from the principles of the present application. These improvements and modifications shall fall within the protection scope of the claims of the present application.

## Claims

1. A plastic encapsulation mold for a semiconductor device, comprising:
a pressing device; and
at least one mold cavity, wherein
the pressing device comprises an ejector pin;
the mold cavity is configured to accommodate the semiconductor device to be encapsulated which has an exposed structure to a bottom surface of the mold cavity, and each mold cavity is formed with a through-hole in its top surface, wherein the through-hole is positioned in alignment with a non-chip-placement region of the semiconductor device; and
the ejector pin is positioned in alignment with the through-hole, and the ejector pin is configured to move through the through-hole into the mold cavity to press against the exposed structure prior to injection molding, and to move away from the exposed structure through the through-hole during the injection molding.

2. The plastic encapsulation mold for the semiconductor device according to claim 1, wherein there are at least two through-holes, and the number of through-holes is identical to the number of ejector pins.

3. The plastic encapsulation mold for the semiconductor device according to claim 1, wherein the pressing device further comprises:
an ejector pin sleeve arranged in the through-hole.

4. The plastic encapsulation mold for the semiconductor device according to claim 3, wherein the ejector pin sleeve is made of a material comprising tungsten steel, and the ejector pin is made of a material comprising high-speed steel.

5. The plastic encapsulation mold for the semiconductor device according to claim 1, wherein the ejector pin has a flat surface at its bottom portion, which is an end portion of the ejector pin for contact with the exposed structure.

6. The plastic encapsulation mold for the semiconductor device according to claim 1, wherein the exposed structure is a heat sink.

7. The plastic encapsulation mold for the semiconductor device according to any one of claims 1 to 6, wherein the pressing device further comprises:
a movement control device connected to a top portion of the ejector pin, wherein the movement control device is configured to control the ejector pin to press against and move away from the exposed structure, and the top portion of the ejector pin is an end portion of the ejector pin away from the exposed structure.

8. The plastic encapsulation mold for the semiconductor device according to claim 7, wherein the movement control device comprises:
a connecting plate connected to the top portion of each ejector pin; and
a pneumatic cylinder connected to the connecting plate and configured to drive the connecting plate to move up and down.

9. The plastic encapsulation mold for the semiconductor device according to claim 8, further comprising:
a buffer member arranged between the top portion of the ejector pin and the connecting plate.

10. The plastic encapsulation mold for the semiconductor device according to claim 9, wherein the buffer member comprises a spring.

11. The plastic encapsulation mold for the semiconductor device according to claim 7, wherein the movement control device further comprises a data acquisition module which is configured to acquire plastic encapsulation data, and the movement control device is configured to, based on the plastic encapsulation data, control the ejector pin to move away from the exposed structure prior to completion of plastic encapsulation.

12. The plastic encapsulation mold for the semiconductor device according to claim 11, wherein the plastic encapsulation data comprises an elapsed plastic encapsulation duration, and the ejector pin is configured to move away from the exposed structure when the elapsed plastic encapsulation duration reaches 60% to 85% of a total injection duration for plastic encapsulation.

13. The plastic encapsulation mold for the semiconductor device according to claim 11, wherein the plastic encapsulation data comprises an amount of plastic encapsulation material used, and the ejector pin is configured to move away from the exposed structure when the amount of plastic encapsulation material used reaches 60% to 85% of a total amount of plastic encapsulation material.

14. A plastic encapsulation method for a semiconductor device, comprising the steps of:
placing the semiconductor device to be encapsulated into a mold cavity of a plastic encapsulation mold;
when the plastic encapsulation mold is closed, moving an ejector pin of a pressing device through a through-hole formed in a top surface of the mold cavity into the mold cavity to press against an exposed structure of the semiconductor device, wherein the through-hole is positioned in alignment with a non-chip-placement region of the semiconductor device, and the exposed structure is located at a bottom portion of the mold cavity; and
injecting encapsulant for plastic encapsulation, and controlling the ejector pin to move away from the exposed structure during injection molding.

15. The plastic encapsulation method for the semiconductor device according to claim 14, wherein when the duration of the ejector pin pressing against the semiconductor device reaches 60% to 85% of a total injection duration for plastic encapsulation, the ejector pin is moved away from the semiconductor device.

16. The plastic encapsulation method for the semiconductor device according to claim 15, wherein the step of moving the ejector pin of the pressing device through the through-hole into the mold cavity to press against the exposed structure of the semiconductor device comprises:
when the plastic encapsulation mold is closed, sending an operational command to a controller from a proximity sensor configured to detect mold closing; and
when the operational command is received by the controller, sending an activation command to a solenoid valve to control a movement control device such that the ejector pin is moved through the through-hole into the mold cavity to press against the exposed structure of the semiconductor device, and sending a timing start command to a timer such that the timer is started to record the duration of the ejector pin pressing against the exposed structure; and
wherein the step of controlling the ejector pin to move away from the exposed structure comprises:
when the duration received by the controller from the timer reaches 60% to 85% of the total injection duration for plastic encapsulation, sending a reset command to the solenoid valve to control the movement control device to reset such that the ejector pin is moved away from the exposed structure.

17. The plastic encapsulation method for the semiconductor device according to claim 14, wherein when an amount of plastic encapsulation material used reaches 60% to 85% of the total amount of plastic encapsulation material, the ejector pin is moved away from the exposed structure.

18. The plastic encapsulation method for the semiconductor device according to claim 14, wherein the step of injecting the encapsulant for plastic encapsulation comprises:
performing a first encapsulant injection for plastic encapsulation; and
performing a second encapsulant injection for plastic encapsulation after the ejector pin is moved away from the exposed structure.

19. A pressing device for plastic encapsulation of a semiconductor device, wherein the pressing device comprises an ejector pin, which is positioned in alignment with a through-hole formed in a top surface of a plastic encapsulation mold for the semiconductor device, the ejector pin is configured to move through the through-hole to press against a target location on the semiconductor device prior to injection molding, and move away from the target location through the through-hole during the injection molding.

20. The pressing device according to claim 19, further comprising:
an ejector pin sleeve, which is arranged in the through-hole.

21. The pressing device according to claim 19, further comprising:
a movement control device connected to a top portion of the ejector pin, wherein the movement control device is configured to control the ejector pin to press against and move away from the target location, and the top portion of the ejector pin is an end portion of the ejector pin away from the target location.

22. The pressing device according to claim 21, wherein the movement control device comprises:
a connecting plate connected to the top portion of each ejector pin; and
a pneumatic cylinder connected to the connecting plate and configured to drive the connecting plate to move up and down.

23. The pressing device according to claim 22, further comprising:
a buffer member arranged between the top portion of the ejector pin and the connecting plate.

24. The pressing device according to any one of claims 21 to 23, wherein the movement control device further comprises a data acquisition module which is configured to acquire plastic encapsulation data, and the movement control device is configured to, based on the plastic encapsulation data, control the ejector pin to move away from the target location prior to completion of plastic encapsulation.

25. A semiconductor device, plastic-encapsulated by using the plastic encapsulation mold according to any one of claims 1 to 13.
